# EUROPÄISCHE PATENTSCHRIFT

(11) **EP 1 094 326 B1**
(45) Veröffentlichungstag und Bekanntmachung des Hinweises auf die Patenterteilung: **14.02.2007**
(21) Anmeldenummer: 00116840.0
(22) Anmeldetag: 04.08.2000
(51) Int. Cl.: G01R 31/36

(54) **Verfahren zur Bestimmung der Startfähigkeit einer Starterbatterie eines Kraftfahrzeuges**
Method for determining the starting ability of a starter-battery of a motor-vehicle
Procédé de détermination de la capacité de démarrage d'une batterie de démarrage d'un véhicule automobile

(30) Priorität: 20.10.1999 DE 19950424
(43) Veröffentlichungstag der Anmeldung: 25.04.2001
(73) Patentinhaber: VB Autobatterie GmbH & Co. KGaA, 30419 Hannover (DE)
(72) Erfinder: Laig-Hörstebrock, Helmut, Dr., 60320 Frankfurt (DE); Meissner, Eberhard, Dr., 65719 Hofheim (DE)
(74) Vertreter: Lins, Edgar

(56) Entgegenhaltungen:
- US-A- 3 997 834
- PATENT ABSTRACTS OF JAPAN vol. 009, no. 257 (P-396), 15. Oktober 1985 (1985-10-15) -& JP 60 105978 A (NISSAN JIDOSHA KK), 11. Juni 1985 (1985-06-11)
- PATENT ABSTRACTS OF JAPAN vol. 009, no. 308 (P-410), 4. Dezember 1985 (1985-12-04) -& JP 60 140163 A (NISSAN JIDOSHA KK), 25. Juli 1985 (1985-07-25)

## Beschreibung

Die Erfindung betrifft ein Verfahren zur Bestimmung der Startfähigkeit der Starterbatterie eines Kraftfahrzeugs. Für die Fähigkeit einer Starterbatterie, ein Kraftfahrzeug mit einem Verbrennungsmotor zu starten, sind der Ladezustand und der Fortschritt der Alterung bzw. der sich abzeichnende Kapazitätsverfall maßgeblich, da dadurch die der Starterbatterie entnehmbare Stromstärke bzw. deren Leistungsabgabe begrenzt wird. Der Motorstart gehört zu den härtesten Beanspruchungen der Batterie im Kraftfahrzeug. Beim Startvorgang erkennt man am deutlichsten, wenn die Leistungsfähigkeit einer Batterie durch Alterung verringert ist.

Für die Abnahme der Belastbarkeit einer Batterie über größere Zeiträume sind einerseits der Anstieg des ohm'schen Innenwiderstandes der Batterie und andererseits Passivierungsphänomene an den aktiven Materialien verantwortlich.

Bei einem modernen Kraftfahrzeug sind die Eigenschaften von Generator, Batterie und elektrischen Verbrauchern so aufeinander abgestimmt, dass es nur noch im Falle einer massiven Fehlbedienung zu so niedrigen Batterieladezuständen kommen kann, dass die Startfähigkeit nicht mehr gewährleistet ist. Daher ist die Frage nach einer zuverlässigen Anzeige für den Austausch der Batterie von großem Interesse, insbesondere wenn sicherheitsrelevante elektrische Verbraucher, wie zum Beispiel elektrische Bremsen oder elektrisch unterstützte Lenkhilfen installiert sind.

Aus dem Dokument DE-C 3901680 ist ein Verfahren zur Überwachung der Kaltstartfähigkeit der Starterbatterie eines Verbrennungsmotors bekannt, bei dem der zeitliche Verlauf des beim Anlassen eintretenden Spannungsabfalls beobachtet und ausgewertet wird. Die Auswertung erfolgt anhand von Grenzwerten einer aus Erfahrungswerten gewonnenen Kennlinie und in Abhängigkeit von der Batterietemperatur.

Das Dokument DE-C 3712629 beschreibt eine Messvorrichtung für die verbleibende Lebensdauer einer Kraftfahrzeugbatterie, die die Batteriespannung und den dazugehörigen Laststromwert vor und nach dem erstmaligen Starten bei vollgeladenem Zustand der Batterie erfasst, den temperaturkompensierten Innenwiderstand ermittelt und in einem Speicher ablegt sowie mit den bei späteren Startvorgängen der Verbrennungskraftmaschine ermittelten Innenwiderstandswerten vergleicht. Die Anzeige erfolgt danach in Abhängigkeit von vorgegebenen abgespeicherten Schwellwerten.

Aus dem Dokument DE-A 19750309 ist ein Verfahren zur Bestimmung der Startfähigkeit der Starterbatterie eines Kraftfahrzeugs zu entnehmen, bei dem der Spannungseinbruch beim Start registriert und abgespeichert wird, wobei Batterie- und Motortemperatur berücksichtigt werden. Die batteriealterungsbedingte Vergrößerung des Spannungseinbruchs im Vergleich zu den Frischwerten wird als Maß für die Batteriealterung verwendet.

Aus dem Dokument WO 99/17128 ist es bekannt, beim Startvorgang die Spannungswerte benachbarter Spannungsminima, die aufgrund der Kompression und Dekompression der Motorkolben auftreten, zu vergleichen. Der Unterschied zwischen diesen Werten dient als Maß für eine Anzeige des Batteriezustands.

In der JP 60 105 978 A ist ein Verfahren zur Bestimmung der Startfähigkeit einer Starterbatterie eines Kraftfahrzeuges beschreiben, bei dem der Strom und die Spannung des Akkumulators vor Startbeginn, kurz nach Startbeginn und in geringen Zeitabständen während des Startvorganges gemessen wird. Aus den Strom/Spannungs-Wertepaaren wird für jeden Zeitpunkt ein Widerstandswert berechnet und mit abgespeicherten Grenzwiderstandswerten verglichen.

Der Erfindung liegt die Aufgabe zugrunde, ein Verfahren zur Bestimmung der Startfähigkeit bzw. der Verfügbarkeit einer zum Starten eines Verbrennungsmotors verwendeten Akkumulatorenbatterie anzugeben, welches den Zustand der Batterie zuverlässig und einfach ermittelt.

Diese Aufgabe wird bei dem im Gattungsbegriff des Anspruchs 1 beschriebenen Verfahren durch die Verfahrensmerkmale des kennzeichnenden Teils des Anspruchs 1 gelöst. Weitere Ausgestaltungen des erfindungsgemäßen Verfahrens sind in den Unteransprüchen angegeben.

Bei dem Verfahren werden Strom und Spannung des Akkumulators vor Startbeginn, kurz nach Startbeginn und in geringen Zeitabständen während des Startvorganges gemessen.

Aus den Strom/Spannungs-Wertepaaren werden für jeden Zeitpunkt ein Widerstandswert und die dem Akkumulator ab Startbeginn entnommene Ladungsmenge berechnet. Aus der Anstiegsrate des Akkumulator-Innenwiderstands, in Abhängigkeit von der entnommenen Ladung, wird ein Maß für die Verfügbarkeit des Akkumulators für den Startvorgang abgeleitet.

Bei dem erfindungsgemäßen Verfahren zur Bestimmung der Startfähigkeit bzw. der Verfügbarkeit einer zum Starten eines Verbrennungsmotors verwendeten Akkumulatorenbatterie wird deutlich zwischen den zwei wesentlichen Ursachen der Batteriealterung unterschieden: dem rein ohmschen Einschaltwiderstand und den während des Starts sich zusätzlich aufbauenden Widerständen. Da jeder Widerstandsanteil für sich den Startvorgang behindern kann, gelten für jeden auch unterschiedliche Grenzbedingungen. Beide Widerstände zusammen sind eine umfassende Beschreibung für die Startfähigkeit einer Batterie.

Zusätzlich kann der Ladezustand und die Batterietemperatur berücksichtigt werden. Der Ladezustand kann beispielsweise aus der vor dem Start gemessenen Ruhespannung abgeschätzt werden. Ein Verfahren zur Abschätzung des Ladezustands aus der Ruhespannung ist in der älteren deutschen Patentanmeldung 198 47 648 beschrieben.

Im Folgenden ist der Gegenstand der Erfindung anhand der Figuren näher erläutert.

Figur 1 zeigt einen charakteristischen Verlauf von Strom und Spannung beim Start eines KFZ mit einer Batterie in gutem Zustand.

In Figur 2 ist der Verlauf der Spannung in Abhängigkeit vom Strom, entsprechend den Werten aus Figur 1, aufgetragen.

Figur 3 zeigt den charakteristischen Verlauf von Strom und Spannung beim Startvorgang einer stark geschwächten Batterie, bei der ein Start nicht mehr glückt.

Figur 4 zeigt eine aus dieser Figur 3 abgeleitete Auftragung der Spannung in Abhängigkeit vom Strom.

Figur 5 schließlich stellt den Innenwiderstand des Akkumulators in Abhängigkeit von der beim Startvorgang entnommenen Ladungsmenge, entsprechend Figur 3, dar.

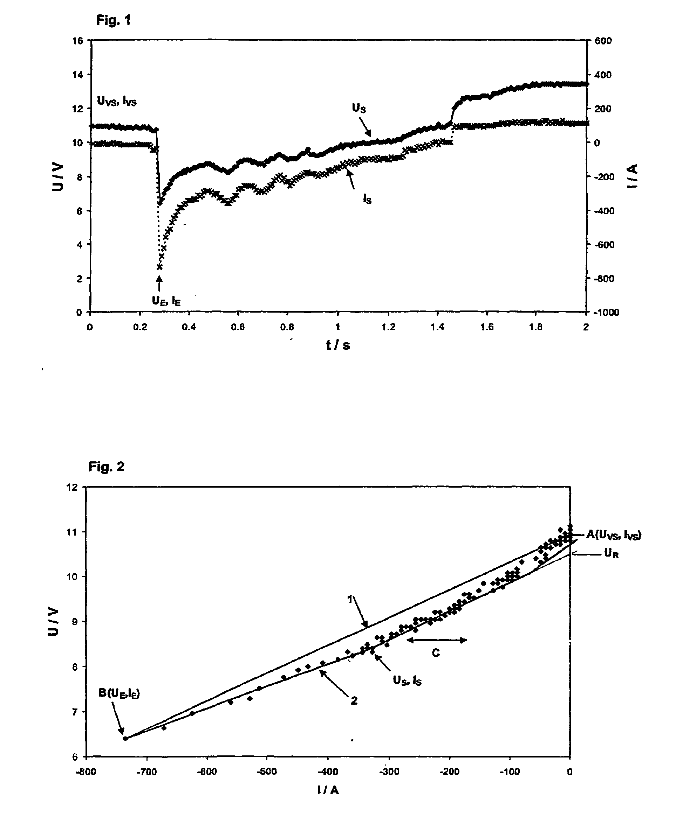

Wie aus Figur 1 ersichtlich, zeigt der Strom beim Einschalten des Startvorganges einen momentanen Spitzenwert, die Spannung einen maximalen Einbruch. Im weiteren Verlauf des Startvorganges wird der Verbrennungsmotor durch den Starter in Bewegung gesetzt, mit der Folge, dass der Strom in Wellen, entsprechend der Kompression und der Dekompression der Zylinder wieder absinkt und die Spannung sich entsprechend erholt. Ist eine Mindestdrehzahl des Verbrennungsmotors erreicht, läuft er selbständig weiter.

Trägt man bei einer wenig gealterten Batterie, deren Verhalten in Figur 1 aufgetragen ist, die Spannung gegen den Strom entsprechend Figur 2 auf, so erhält man einen relativ linearen Verlauf entsprechend Kurve 2. In Figur 2 entspricht Punkt A dem Wertepaar (U_{VS}, I_{VS}) das sind Spannung und Strom vor dem Start, wobei im allgemeinen noch eine geringe Belastung durch übliche Verbraucher vorliegt. Der Zeitpunkt dieser Messung ist nicht besonders kritisch. Es kann direkt vor dem Start, aber auch mehrere Sekunden vorher, zum Beispiel 2 Sekunden vorher gemessen werden, wenn sonst keine starken Lasten eingeschaltet sind.

Punkt B in Figur 2 zeigt das Wertepaar (U_{E}, I_{E}), nämlich Spannung und Strom kurz nach dem Startbeginn. Es wird angestrebt, den Zeitpunkt des Maximalstromes zu wählen. Genügend genau ist aber meist eine Messung spätestens ca. 0,02 Sekunden nach dem Startbeginn. Die Steigung der Verbindungslinie zwischen Punkt A und B bzw. der Quotient von U_{VS} - U_{E} und I_{E} - I_{VS} ist der Einschaltinnenwiderstand R_{E}.

In Kurve 2 sind im Verlauf des Startvorganges als Punkte in kurzen Zeitabständen gemessene Werte von U_{S} und I_{S} während des Startvorganges aufgetragen. Die Messzeitpunkte haben beispielsweise einen Abstand von 0,01 Sekunden. Grundsätzlich ist der Abstand der Messzeitpunkte so zu wählen, dass eine ausreichende Auflösung des Startvorganges erfolgt, d.h. der zeitliche Abstand kann zwischen 0,001 sec und 0,1 sec. liegen. Es muss nur für eine ausreichende Anzahl von Messwerten gesorgt werden, beispielsweise 100 Messwerte bei einer normalen durchschnittlichen Startdauer von 1 sec.

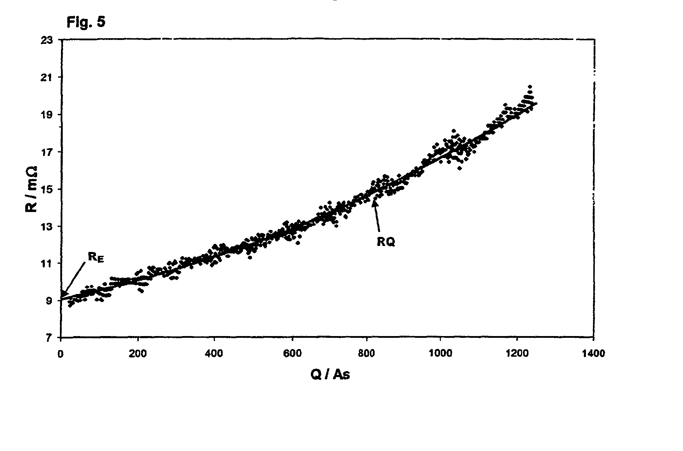

In Figur 5 ist für jeden Messzeitpunkt der Innenwiderstand des Akkumulators gegenüber der dem Akkumulator entnommenen Ladungsmenge aufgetragen. Die Steigung der Widerstandsgeraden in Abhängigkeit von der umgesetzten Ladungsmenge wird erfindungsgemäß als Alterungsmaß verwendet. Im vorliegenden Beispiel ist in einem Bereich von 0 bis ca. 1 Sekunde die Änderung des Widerstands pro umgesetzter Ladungsmenge ΔRQ bzw. das Alterungsmaß weitgehend unabhängig vom Zeitpunkt der Bestimmung.

Wenn die Messwerte gegenüber den Ausgleichskurven eine verhältnismässig große Streuung besitzen, ist es vorteilhaft, weitere Rechengrößen in die Ermittlung des Alterungsmaßes einzubeziehen.

In Kurve 2 ist von besonderem Interesse der Bereich C, der zu Linie 1 etwa parallel ist, das heißt, der Bereich, in dem die Steigung R_{S} von Kurve 2 etwa dem Wert R_{E} entspricht.

Es wird also ein Spannungs- und Strompaar (U_{S}, l_{S}) in dem Zeitbereich bestimmt, in dem die Steigungen R_{E} und R_{S} möglichst gleich groß sind, wobei die Bestimmung von R_{S} als Neigung der Kurve 2 mit U I Werten zu jeweils zwei Zeitpunkten erfolgt, die beispielsweise 0.2 s auseinanderliegen. Die Tangente an Kurve 2 im Parallelbereich zu Kurve 1 schneidet die Spannungskoordinate (I = O) bei der Ersatzruhespannung U_{R}. Diese Tangente ist praktisch die Widerstandsgerade der Batterie im startrelevanten Bereich.

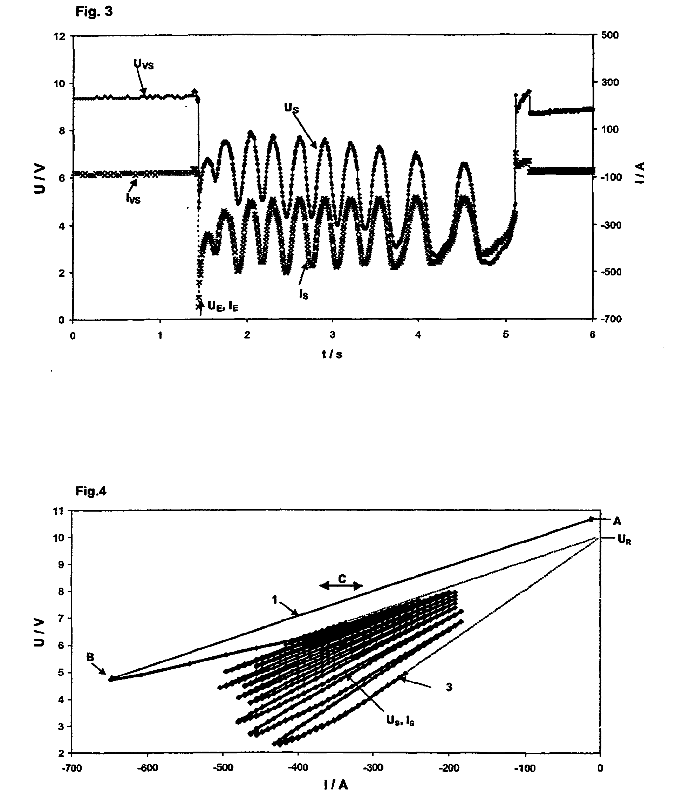

Verfährt man in gleicher Weise mit der Stromspannungskennlinie der Figur 3, so ergibt sich in Figur 4 die Darstellung von Spannung in Abhängigkeit vom Strom bei einer sehr stark geschwächten Batterie. Es ist ersichtlich, dass der Innenwiderstand, repräsentiert durch die einzelnen Punkte in Figur 4, anwächst.

Legt man in dieser Darstellung Tangenten in die zugehörigen Strom-Spannungs-Werte, so ist ersichtlich, dass die Tangenten sich auffächern bzw. dass die Steigung der Tangenten bzw. der Innenwiderstand anwächst. Bei der mit 3 in Figur 4 bezeichneten Linie ist ein Maximum des Innenwiderstandes erreicht. Alle Tangenten haben einen gemeinsamen Ausgangspunkt, der etwa bei U_{R} liegt. Durch diese Kenntnis ist es möglich, die Streuung der Messwerte zu korrigieren.

Der Wert ΔRQ sowie der Einschaltwiderstand R_{E} werden in einem Rechenspeicher als Feld in Abhängigkeit vom Ladezustand bzw. der Ersatzruhespannung und der Batterietemperatur abgelegt und werden mit schon registrierten Werten oder typischen Normwerten verglichen. Größere Abweichungen, wie zum Beispiel eine Steigung ΔRQ > 0,001 mΩ/As (ermittelt bei einer üblichen Starterbatterie mit 60 Ah) weisen auf fortgeschrittene Batteriealterung oder Mangelladung hin. Die Unterscheidung, ob es sich dabei um Batteriealterung oder mangelnde Ladung handelt, ergibt sich aus dem Ladezustand. Bei einem Ladezustand von mehr als beispielsweise 40% sollte es bei normalen Wintertemperaturen keine Startprobleme geben.

Bei frischen Batterien in ausreichend hohem Ladezustand oder bei hohen Batterietemperaturen verläuft der Startvorgang meist so schnell, dass eine Auswertung nicht möglich ist. Eine Auswertung ist in diesen Fällen aber auch nicht notwendig und die Steigung der Widerstandsgeraden ΔRQ kann gleich Null gesetzt werden. Mit beginnender Alterung der Batterie jedoch ergibt die Auswertung diskrete Werte, so dass frühzeitig genug beispielsweise mit einem Batterieaustausch reagiert werden kann. Die erfindungsgemäß bestimmte Leistungsverschlechterung der Batterie kann, wenn zum Beispiel ein vorgegebener Grenzwert überschritten wird, dem Fahrer angezeigt werden, oder es können automatische Konsequenzen, beispielsweise bei der Ladetechnik, durch Anstreben eines höheren Ladezustandes, um die voranschreitende Alterung zu kompensieren, ausgelöst werden. Derartige Änderungen können selbstverständlich nicht nur bei Erreichen eines Schwellwertes, sondern auch graduell, auf der Basis ermittelter Mittelwerte bewirkt werden. Schließlich kann aus einer scheinbaren plötzlichen Verbesserung der Batterie auf einen etwa vorgenommenen Austausch geschlossen werden.

## Patentansprüche

1. Verfahren zur Bestimmung der Startfähigkeit der Starterbatterie eines Kraftfahrzeugs, wobei Strom und Spannung der Starterbatterie vor Startbeginn, U_{VS}, I_{VS}, kurz nach Startbeginn, U_{E}, I_{E}, und in geringen Zeitabständen während des Startvorganges, U_{S}, I_{S}, gemessen werden und aus den Strom-Spannungs-Wertepaaren (U, I) für jeden Zeitpunkt ein Widerstandswert berechnet wird, ***dadurch gekennzeichnet, dass*** aus den Strom-Spannungs-Wertepaaren für jeden Zeitpunkt die der Starterbatterie entnommene Ladungsmenge berechnet wird und dass aus der Anstiegsrate der Widerstandswerte in Abhängigkeit von der entnommenen Ladungsmenge ein Maß für die Startfähigkeit der Starterbatterie abgeleitet wird.

2. Verfahren nach Anspruch 1, **dadurch gekennzeichnet, dass** Spannung und Strom vor dem Start, U_{VS}, I_{VS}, und spätestens 0,02 sec nach dem Startbeginn U_{E}, I_{E}, gemessen werden.

3. Verfahren nach Anspruch 1 oder 2, **dadurch gekennzeichnet, dass** die Zeitabstände zwischen den Spannungs- und Strommessungen zwischen 0,001 und 0,1 sec, vorzugsweise bei ca. 0,01 sec liegen.

4. Verfahren nach den Ansprüchen 1 bis 3, **dadurch gekennzeichnet, dass** zur Bestimmung einer Ersatzruhespannung U_{R}, die zur Bestimmung des Ladezustands der Starterbatterie geeignet ist, ein Spannungs- und Strom-Werte paar U_{S}, I_{S}, in dem Zeitbereich bestimmt wird, in dem ein Einschaltwiderstand R_{E}, der aus dem Quotienten von U_{VS} - U_{E} und I_{E} - I_{VS} definiert ist, und ein Widerstand R_{S} = ΔU_{S} / ΔI_{S} möglichst gleich groß sind, wobei die Bestimmung von R_{S} als Steigung der Strom-Spannung-Linie (2) zu jeweils zwei Zeitpunkten erfolgt, die durch einen längeren Messzeitraum getrennt sind.

5. Verfahren nach Anspruch 4, **dadurch gekennzeichnet, dass** der Messzeitraum ca. 0,2 sec beträgt.

6. Verfahren nach einem der Ansprüche 1-5, **dadurch gekennzeichnet, dass** der Ladezustand aus der Ruhespannung vor dem Start abgeschätzt wird.

7. Verfahren nach einem der Ansprüche 1-6, **dadurch gekennzeichnet, dass** die Steigung ΔRQ des Innenwiderstands der Starterbatterie in Abhängigkeit von der entnommenen Ladungsmenge und der Einschaltwiderstand R_{E}, der aus dem Quotienten von U_{VS} - U_{E} und I_{E} - I_{VS} definiert ist, in einem Rechenspeicher als Feld in Abhängigkeit vom Ladezustand oder einer Ersatzruhespannung (U_{R}) und der Batterietemperatur abgelegt und mit bereits registrierten Werten oder typischen Normalwerten verglichen werden.

## Claims

1. Method for determining the starting ability of the starter battery in a motor vehicle, wherein the current and voltage of the starter battery are measured before starting is begun U_{VS}, l_{VS}, shortly after starting is begun U_{E}, I_{E} and at short intervals of time during the starting procedure U_{S}, I_{S}, wherein the current voltage value pairs (U, I) for each instant are used to calculate a resistance value, **characterised in, that** the quantity of charge drawn from the storage battery is calculated from the current-voltage value pairs for each instant and that the rate of rise in the resistance values as a function of the quantity of charge drawn is used to derive a measure of the starting ability of the starter battery during the starting procedure.

2. Method as claimed in claim 1, **characterised in, that** voltage and current are measured before starting U_{VS}, I_{VS} and no later than 0.02 sec. after starting is begun U_{E}, I_{E}.

3. Method as claimed in claim 1 or 2, **characterised in, that** that time intervals between the voltage and current measurements are between 0.001 and 0.1 sec., and are preferably approximately 0.01 sec.

4. Method as claimed in claims 1 to 3, **characterised in, that** to determine an equivalent no-load voltage UR suitable for determining the charge state of the starter battery, voltage and current pairs U_{S}, I_{S} are determined in the time range in which the turn-on resistance RE defined by the quotient of U_{VS} - U_{E} and I_{E} - I_{US} and the resistance R_{S} = ΔU_{S}/ΔI_{S} are as near to the same size as possible, wherein R_{S} is determined as the gradient of the current voltage line (2) at two respective instants which are separated by a longer measurement period.

5. Method as claimed in claim 4, **characterised in, that** the measurement period is approximately 0.2 sec.

6. Method as claimed in one of claims 1-5, **characterised in, that** the charge state is estimated from the no-load voltage before starting.

7. Method as claimed in one of claims 1-6, **characterised in, that** the gradient ΔRQ of the internal resistance of the starter battery as a function of the quantity of charge drawn and the turn-on resistance R_{E} defined by the quotient of U_{VS} - U_{E} and I_{E} - I_{VS} are stored in an arithmetical memory as a field as a function of the charge state or of the equivalent no-load voltage (U_{R}) and the battery temperature and are compared with already recorded values or typical normal values.

## Revendications

1. Procédé de détermination de la capacité de démarrage de la batterie de démarrage d'un véhicule automobile, selon lequel on mesure le courant et la tension de la batterie de démarrage avant le début du démarrage, U_{VS}, I_{VS}, peu après le début du démarrage, U_{E}, I_{E}, et à faibles intervalles de temps pendant le processus de démarrage, U_{S}, I_{S}, et à partir des paires de valeurs courant-tension (U, I) on calcule pour chaque instant une valeur de résistance,
**caractérisé en ce qu'**
à partir des paires de valeurs courant-tension on calcule pour chaque instant la quantité de charge prélevée de la batterie de démarrage et on déduit, à partir de la vitesse d'élévation des valeurs de résistance en fonction de la quantité de charge prélevée, une mesure de la capacité de démarrage de la batterie de démarrage.

2. Procédé selon la revendication 1,
**caractérisé en ce qu'**
on mesure la tension et le courant avant le démarrage, U_{VS}, I_{VS}, et au plus tard 0,02 seconde après le début du démarrage, U_{E}, I_{E}.

3. Procédé selon la revendication 1 ou 2,
**caractérisé en ce que**
les intervalles de temps entre les mesures de la tension et du courant sont de 0,001 à 0,1 seconde, de préférence d'environ 0,01 seconde.

4. Procédé selon les revendications 1 à 3,
**caractérisé en ce que**
pour déterminer une tension de repos de remplacement U_{R}, qui convient pour déterminer l'état de charge de la batterie de démarrage, une paire de valeurs de tension et de courant, U_{S}, I_{S}, est déterminée dans la plage de temps dans laquelle une résistance de commutation R_{E}, définie à partir des quotients de U_{VS}-U_{E} et I_{E}-I_{VS}, et une résistance R_{S} = ΔU_{S} / ΔI_{S} sont autant que possible égales, et la détermination de R_{S} est faite par la pente de la courbe courant-tension (2) à respectivement deux instants qui sont séparés par un intervalle de temps de mesure plus long.

5. Procédé selon la revendication 4,
**caractérisé en ce que**
l'intervalle de temps de mesure est d'environ 0,2 seconde.

6. Procédé selon l'une des revendications 1 à 5,
**caractérisé en ce que**
l'état de charge est évalué à partir de la tension de repos avant le démarrage.

7. Procédé selon l'une des revendications 1 à 6,
**caractérisé en ce que**
la pente ΔRQ de la résistance intérieure de la batterie de démarrage en fonction de la quantité de charge prélevée et la résistance de commutation R_{E} définie à partir des quotients de U_{VS}-U_{E} et I_{E}-I_{VS} sont archivées dans une mémoire de calculateur, en tant que champ en fonction de l'état de charge ou d'une tension de repos de remplacement (U_{R}) et de la température de la batterie, et sont comparées avec des valeurs déjà enregistrées ou des valeurs normales typiques.
